# FASCICULE DE BREVET EUROPEEN

(11) **EP 0 410 911 B1**
(45) Date de publication et mention de la délivrance du brevet: **27.12.1995**
(21) Numéro de dépôt: 90420355.1
(22) Date de dépôt: 23.07.1990
(51) Int. Cl.: H01L 27/088, H01L 27/07, H01L 27/06, H01L 29/861, H01L 29/872, H01L 21/82

(54) **Procédé de fabrication d'un circuit intégré à transistors de puissance et logiques comprenant une diode.**
Prozess zur Herstellung eines integrierten Leistungstransistor/Logik-Schaltkreises mit einer Diode.
Process of manufacturing an integrated power transistor/logic circuit comprising a diode.

(30) Priorité: 27.07.1989 FR 8910386
(43) Date de publication de la demande: 30.01.1991
(73) Titulaire: SGS-THOMSON MICROELECTRONICS S.A., 94250 Gentilly (FR)
(72) Inventeur: Quessada, Daniel, F-83910 Pourrieres (FR)
(74) Mandataire: de Beaumont, Michel

(56) Documents cités:
- EP-A- 0 123 093
- EP-A- 0 213 425
- EP-A- 0 294 888
- DE-A- 3 601 326
- FR-A- 2 301 096

## Description

La présente invention concerne le domaine des circuits intégrés de puissance incluant une partie logique sur la même puce. Elle concerne plus particulièrement des structures de type VDMOS ou de type transistor bipolaire vertical dans lesquelles sont également réalisés des circuits logiques à transistors MOS à canal N de type latéral enrichis et déplétés.

On va tout d'abord rappeler de façon détaillée la structure de circuit intégré considérée qui est déjà décrite par exemple dans la demande de brevet européen EP-A- 0 236 200 au nom de Thomson CSF.

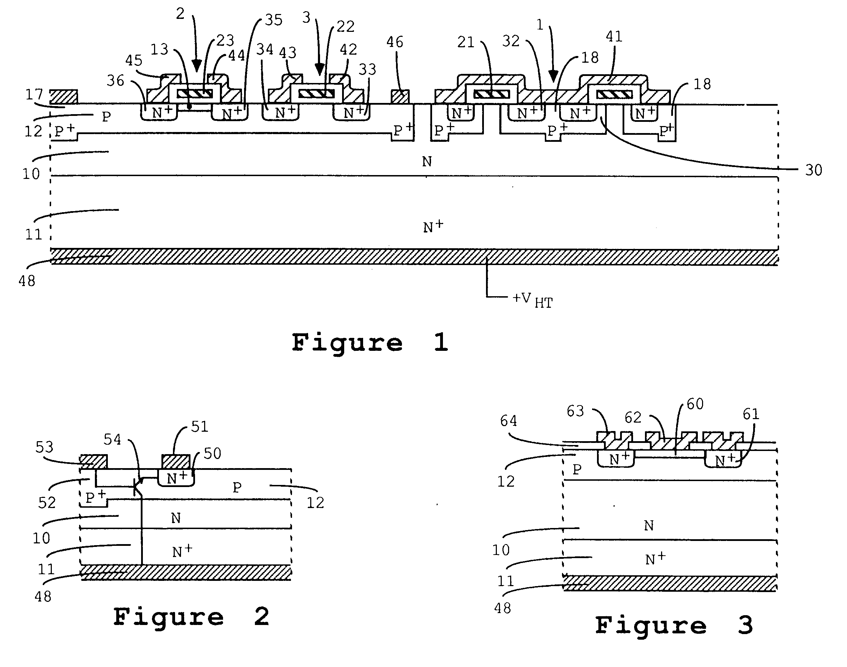

La figure 1 est une vue en coupe fortement schématique d'une telle structure. Seuls certains éléments de cette structure sont représentés par souci de simplification (en particulier certaines couches d'oxyde mince et épais ne sont pas représentées). La partie droite de la figure illustre une structure de puissance 1 de type VDMOS (transistor MOS vertical à canal diffusé) à enrichissement et la partie gauche de la figure représente des composants logiques tels qu'un transistor MOS latéral à canal N déplété 2 et un transistor MOS latéral à canal N enrichi 3.

Cette structure est réalisée sur un substrat comprenant une couche 10 de type N formée par épitaxie sur une plaquette de silicium 11 de type N⁺.

Dans une première étape de dopage, on forme des régions 12 de type P correspondant notamment à des caissons dans lesquels sera élaborée la partie logique de la puce.

Dans une deuxième étape de dopage, on forme des régions P⁺ à niveau de dopage élevé, suffisamment élevé pour obtenir un contact ohmique avec des métallisations. Ces régions P⁺ sont par exemple des régions 17 permettant de prendre un contact ohmique avec le caisson 12 et des régions 18 du transistor de puissance VDMOS permettant de prendre un contact avec la région dans la partie superficielle de laquelle se forme le canal (région dite de bulk).

Dans une troisième étape de dopage, on forme des régions 13 de type N correspondant notamment aux régions de canal des transistors MOS latéraux déplétés.

Ensuite, on forme de façon classique (par exemple par oxydation, dépôt de silicium polycristallin, gravure et réoxydation) les grilles 21 du transistor de puissance, 22 des transistors MOS latéraux enrichis, et 23 des transistors MOS latéraux déplétés (ces grilles sont formées simultanément).

Une quatrième étape de dopage de type P dans la région du transistor VDMOS sert à former les régions de canal 30 de ces transistors, les régions de grille servant de masque.

Après cela, dans une cinquième étape de dopage, on forme, en utilisant encore notamment les grilles susmentionnées comme masque, des régions N⁺ correspondant notamment aux sources 32 du transistor de puissance et aux sources et drains 33 à 36 des transistors MOS latéraux enrichis et déplétés.

Enfin, après oxydation et ouverture des fenêtres appropriées, on forme une couche de métallisation dans laquelle on découpe la métallisation de source 41 du transistor de puissance, et les métallisations de source et de drain 42 à 45 des transistors latéraux ainsi que d'autres métallisations telles que des métallisations 46 de contact des caissons dans lesquels sont formés les composants logiques.

D'autre part, la face arrière du composant qui correspond au drain du transistor VDMOS 1 est recouverte d'une métallisation 48.

En fonctionnement, une telle structure est généralement connectée de sorte que sa face arrière 48 est au potentiel le plus positif (+V_{HT}), toutes les autres métallisations étant à des potentiels inférieurs et la métallisation 46 du caisson 12 étant couramment connectée à la masse.

La structure ci-dessus décrite est particulièrement attrayante par sa simplicité. En effet, elle nécessite un nombre minimal d'étapes de masquage et de dopage. Comme on l'a vu précédemment, seulement cinq types de dopage sont prévus.

Toutefois, cette simplicité entraîne que le nombre de de composants réalisables dans une telle structure est limité.

Or, les utilisateurs aimeraient, tout en conservant les avantages de faible prix et de fiabilité qui y sont associés, disposer de composants élémentaires supplémentaires, tels par exemple que des diodes PN susceptibles de fonctionner dans le sens direct (conductrices avec une tension sur la région P supérieure à la tension sur la région N).

La figure 2 représente le schéma élémentaire de réalisation d'une telle diode PN dans une structure du type de celle de la figure 1. La diode PN est réalisée entre la région dopée de type P du caisson 12 et une région 50 de type N⁺ réalisée dans ce caisson 12. La surface supérieure de la région N⁺ 50 est revêtue d'une métallisation 51 et une région P⁺ 52 formée dans le caisson 12 est revêtue d'une métallisation 53. On obtient bien ainsi une diode susceptible de fonctionner dans le sens direct entre les métallisations 53 et 51.

Toutefois, en pratique, une telle structure ne peut pas être utilisée. En effet, selon un premier inconvénient, le caisson sera au potentiel fixé par la connexion à la métallisation 53 et ne pourra plus être maintenu à la masse comme cela est souhaitable. Mais surtout, selon un deuxième inconvénient rédhibitoire, quand la diode PN est passante et qu'un courant circule de la métallisation 53 vers la métallisation 51, ce courant constitue le courant de base d'un transistor NPN parasite 54 dont l'émetteur correspond à la région 50, la base au caisson P 12 et le collecteur au substrat NN⁺ relié à la métallisation 48. Ce transistor parasite est un transistor de bonne qualité, c'est-à-dire qu'il a un gain élevé. Si ce gain est de l'ordre de 20 à 50, cela signifie que, chaque fois qu'il passe un courant entre les métallisations 53 et 51, il passera un courant 20 à 50 fois plus important entre les métallisations 48 et 51. Ce courant dans le transistor parasite est en parallèle sur le composant de puissance et peut être un courant très important qui provoquera l'échauffement et éventuellement la destruction de la structure.

Ainsi, il n'est pas possible de réaliser simplement avec la technologie susmentionnée des diodes susceptibles de fonctionner en sens direct. Pour résoudre ce problème, on a dans l'art antérieur eu recours, ou bien, à des technologies plus complexes en rajoutant des caissons supplémentaires mais sans s'affranchir pour autant complètement des problèmes de transistors parasites, ou bien, à des structures dites de diodes actives dans lesquelles une détection de polarité entraîne la mise en conduction d'un transistor MOS. Cette deuxième solution peut être satisfaisante mais exige l'emploi de circuits relativement complexes qui occupent une surface de silicium importante.

Ainsi, un objet de la présente invention est de résoudre le problème de la réalisation d'une diode dans un circuit intégré réalisé en seulement cinq étapes de dopage et incluant des transistors MOS de puissance verticaux de type VDMOS et des transistors logiques latéraux, ceci étant réalisé tout en maintenant une technologie à seulement cinq étapes de dopage et à un seul niveau de métallisation.

Pour atteindre ces objets ainsi que d'autres, la présente invention prévoit un circuit intégré comprenant des éléments de puissance du type transistor vertical et des éléments logiques du type transistor MOS latéral déplétés et enrichis, et comprenant aussi une diode, ce circuit intégré étant réalisé par le procédé selon la revendication 1.

Selon un mode de réalisation de l'invention, la couche de métallisation est une couche d'aluminium-silicium à environ 1% de silicium obtenue par pulvérisation cathodique.

Ces objets, caractéristiques et avantages de la présente invention seront décrits plus en détail dans la description suivante d'un mode de réalisation particulier faite en relation avec les figures jointes parmi lesquelles :
la figure 1, destinée à exposer l'état de la technique, a été décrite précédemment ;
la figure 2, destinée à exposer le problème posé, a été décrite précédemment ; et
la figure 3 représente une vue en coupe schématique d'une structure selon la présente invention.

Dans ces diverses figures, on notera que les dimensions latérales et les épaisseurs des diverses couches ne sont pas tracées à l'échelle conformément à l'usage dans le domaine de la représentation des circuits intégrés mais que ces diverses couches ou portions de couches sont arbitrairement dilatées pour améliorer la lisibilité des figures.

La figure 3 représente une vue en coupe partielle d'un composant selon la présente invention formé dans une structure du type de celle de la figure 1. Selon l'invention, dans le caisson P 12, on forme une région 60 de type N résultant du même dopage que la région 13 de la figure 1 correspondant aux canaux des transistors MOS latéraux déplétés. Cette région 60 est entourée d'un anneau 61 de type N⁺ correspondant à la même étape de dopage que les régions de drain et de source 32 à 36 des transistors MOS. La couche de métallisation est gravée de façon à former une métallisation 62 en contact avec la face supérieure de la région N 60 et une métallisation 63 en contact avec l'anneau de type N⁺ 61.

On a en outre illustré dans cette figure une couche d'oxyde de silicium 64, qui existait déjà dans les structures antérieures bien qu'elle n'ait pas été représentée. Les métallisations 62 et 63 sont, selon un aspect important de la présente invention, des portions de la même métallisation que les métallisations 41 à 45 de la figure 1. Il pourra par exemple s'agir d'aluminium-silicium.

Grâce à cette structure, on obtient une diode fonctionnant dans le sens direct entre les métallisations 62 et 63. Cette diode a la structure d'une diode Schottky mais est en fait quelque peu intermédiaire dans son fonctionnement entre une diode Schottky et une diode PN classique quand la métallisation est une métallisation d'aluminium-silicium car il se produit vraisemblablement une certaine diffusion d'aluminium dans la couche 60 de type N pour former une jonction PN. Dans ce cas, même s'il existe un transistor PNP parasite entre la diffusion résultant de la métallisation 62, la région de type N 60 et le caisson P 12, ce transistor aura un gain très inférieur à 1.

Dans le cas où la technologie utilisée implique que la diffusion de type N 60, correspondant au canal déplété des transistors MOS latéraux, a une profondeur de jonction de 0,7 micromètre et une concentration en surface de quelques 10¹⁶ atomes par cm³, les métallisations étant réalisées par pulvérisation cathodique d'aluminium à 1 % de silicium, on obtient une diode dont la chute de tension en direct VF est dans la plage de 0,4 à 0,6 volt, dont la tenue en tension inverse est de 30 volts et dont le courant de fuite est inférieur à 1 microampère pour une tension inverse de l'ordre de 30 volts. Le gain du transistor PNP parasite était alors inférieure à 10⁻³.

Ainsi, grâce à la présente invention, on a réalisé une diode pouvant fonctionner en direct sans ajouter une seule étape au processus technologique classique de fabrication de structures à transistor de puissance VDMOS et à transistors logiques de type MOS latéral enrichi et déplété.

On pourra apporter diverses modifications à cette structure, par exemple remplacer sur toute la surface supérieure du composant la métallisation en Al-Si par une autre métallisation mieux adaptée à la formation d'une diode Schottky sur une couche N faiblement dopée tout en conservant de bonnes caractéristiques de contact ohmique et de conductivité pour les contacts N⁺ et P⁺.

Par ailleurs, bien que la présente invention ait été décrite en détail dans le cas où le transistor de puissance vertical est de type MOS, elle s'applique également au cas où ce transistor est de type bipolaire.

## Revendications

1. Procédé de fabrication d'un circuit intégré comprenant des éléments de puissance du type transistor vertical (1), des éléments logiques du type transistor MOS latéral déplétés (2) et enrichis (3) et une diode, dans un substrat épitaxié de type N/N⁺ (10, 11), comprenant les étapes suivantes :
- une première étape de dopage de type P pour fournir notamment des zones correspondant à un caisson (12) dans lequel seront formés les transistors logiques,
- une deuxième étape de dopage de type P à dopage élevé permettant l'établissement de contacts ohmiques (17, 18),
- une troisième étape de dopage de type N pour former notamment les zones de canal (13) des transistors MOS déplétés,
- une quatrième étape de dopage de type P pour fournir des zones (30) correspondant aux régions de canal d'un transistor de puissance MOS vertical ou de base d'un transistor de puissance bipolaire vertical,
- une cinquième étape de dopage de type N à dopage élevé permettant l'établissement de contacts ohmiques (32-36),
- une seule étape de métallisation pour former par gravure diverses régions métallisées,
caractérisé en ce que ladite diode ayant la structure d'une diode Schottky est formée dans un caisson (12) résultant de la première étape de dopage par les étapes suivantes :
- former lors de la troisième étape de dopage une première région (60) dans ledit caisson (12),
- former lors de la cinquième étape de dopage un anneau (61) en contact physique périphérique avec la première région (60),
- former lors de l'étape de métallisation une métallisation d'anode (62) sur la première région et une métallisation de cathode (63) sur l'anneau.

2. Procédé selon la revendication 1, caractérisé en ce que la troisième étape de dopage fournit des régions de type N d'un niveau de dopage de l'ordre de 10¹⁶ atomes/cm³.

3. Procédé selon la revendication 2, caractérisé en ce que la couche de métallisation formée lors de l'étape de métallisation est une couche d'aluminium-silicium à environ 1% de silicium obtenue par pulvérisation cathodique.

## Patentansprüche

1. Verfahren zum Herstellen einer integrierten Schaltung, mit Leistungselementen des vertikalen Transistortyps (1), logischen Elementen des verarmten (2) und des angereicherten (3) lateralen MOS-Transistortyps und einer Diode, in einem epitaktischen Substrat (10, 11) des N/N⁺-Typs, mit den folgenden Verfahrensschritten:
- einem ersten P-Dotierungsschritt, um insbesondere Bereiche zu bilden, welche einer Senke (12) entsprechen, in der logische Transistoren gebildet werden,
- einem zweiten P-Dotierungsschritt mit einem hohen Dotierungspegel, welcher es erlaubt, ohmsche Kontakte (17, 18) einzurichten,
- einem dritten N-Dotierungsschritt, um insbesondere die Kanalbereiche (13) der MOS-Verarmungstransistoren zu bilden,
- einem vierten P-Dotierungsschritt zum Bilden der Bereiche (30), welche den Kanalbereichen eines vertikalen MOS-Leistungstransistors oder den Basisbereichen eines vertikalen bipolaren Leistungstransistors entsprechen,
- einem fünften N-Dotierungsschritt mit einem hohen Dotierungspegel, welcher es erlaubt, ohmsche Kontakte (32-36) einzurichten,
- einem einzigen Metallisierungsschritt zum Bilden verschiedener metallisierter Gebiete durch Ätzen,
dadurch **gekennzeichnet**, daß die Diode, welche eine Schottky-Struktur aufweist, in einer Senke (12), welche sich aus dem ersten Dotierungsschritt ergibt, durch die folgenden Verfahrensschritte ausgebildet wird:
- Bilden eines ersten Gebietes (60) in der Senke (12) während des dritten Dotierungsschrittes,
- Bilden eines Ringes (61) während des fünften Dotierungsschrittes, welcher in physischem Umfangskontakt mit dem ersten Gebiet (60) steht,
- Bilden einer Anodenmetallisierung (62) auf dem ersten Gebiet und einer Kathodenmetallisierung (63) auf dem Ring während des Metallisierungsschrittes.

2. Verfahren nach Anspruch 1, dadurch **gekennzeichnet**, daß der dritte Dotierungsschritt Gebiete des N-Typs vorsieht, welche einen Dotierungspegel in der Größenordnung von 10¹⁶ Atomen/cm³ haben.

3. Verfahren nach Anspruch 2, dadurch **gekennzeichnet**, daß die während des Metallisierungsschrittes gebildete Metallisierungsschicht eine Aluminium-Silizium-Schicht mit ungefähr 1% Silizium ist, welche durch Kathodenzerstäubung erhalten wird.

## Claims

1. A method for manufacturing an integrated circuit comprising power elements of the vertical transistor type (1), logic elements comprising lateral MOS transistors of the depleted (2) and enhanced (3) type, and a diode, in an N/N⁺ epitaxial substrate (10, 11) comprising the following steps:
- a first P-type doping step, for forming in particular areas corresponding to a well (12) wherein will be formed logic transistors,
- a second P-type doping step with a high doping level permitting to establish ohmic contacts (17, 18),
- a third N-type doping step for forming channel regions (13) of the depleted MOS transistors,
- a fourth P-type doping step for forming regions (30) corresponding to channel regions of a vertical power MOS transistor or to base regions of a vertical bipolar power transistor,
- a fifth N-type doping step with a high doping level permitting to establish ohmic contacts (32-36),
- a single metallization step for forming through etching various metallized regions,
characterized in that said diode having a Schottky structure is formed in a well (12) resulting from the first doping step through the following steps:
- forming, during the third doping step, a first region (60) in said well (12),
- forming, during the fifth doping step, a ring (61) having a peripheral physical contact with the first region (60),
- forming, during the metallization step, an anode metallization (61) on the first region and a cathode metallization (63) on the ring.

2. A method according to claim 1, characterized in that the third doping step provides N-type regions having a doping level of approximately 10¹⁶ atoms/cm3.

3. A method according to claim 2, characterized in that the metallization layer formed during the metallization step is an aluminum-silicon layer with a silicon dose of approximately 1% obtained through cathodic sputtering.
